# EUROPEAN PATENT SPECIFICATION

(11) **EP 1 006 219 B1**
(45) Date of publication and mention of the grant of the patent: **27.12.2006**
(21) Application number: 99123238.0
(22) Date of filing: 26.11.1999
(51) Int. Cl.: C30B 25/14, C23C 16/44, B67D 5/02, G01F 23/296

(54) **Ultrasonic level sensing in a chemical refill system**
Ultraschall-Füllstandmessung in einem chemischen Nachfüllsystem
Détection de niveau par ultrasons dans un système de remplissage chimique

(30) Priority: 30.11.1998 US 201005
(43) Date of publication of application: 07.06.2000
(73) Proprietor: AIR PRODUCTS AND CHEMICALS, INC., Allentown, PA 18195-1501 (US)
(72) Inventor: Zorich, Robert Sam, Carlsbad, CA 92009 (US); Voloshin, George Oleg, San Diego, CA 92126 (US)
(74) Representative: Schwabe - Sandmair - Marx

(56) References cited:
- US-A- 4 545 245
- US-A- 4 859 375
- US-A- 4 901 245
- US-A- 5 383 574

## Description

### BACKGROUND OF THE INVENTION

This invention pertains to vapor delivery systems of the type used in semiconductor manufacturing and in particular to a system for transferring reagent chemicals from a bulk storage system to a small use vessel.

The use of chemical reagents to produce various types of semiconductor devices is well known. These chemicals are typically packaged in sealed containers so that there is very little chance of contamination of the reagent prior to its being delivered to the point of use in the semiconductor manufacturing process. A good background description of chemical refill systems that are used to replenish the supply of reagents in a bubbler or ampoule is set forth in US Patent 4,859,375.

In addition, state of the art chemical delivery systems are available from Schumacher, a unit of Air Products and Chemicals Inc. located in Carlsbad, California.

The bubbler or ampoule used to provide the chemical reagent for effecting treatment of a silicon wafer to produce the semiconductor device is usually contained in the clean room portion of the semiconductor fabrication facility or Fab as they are often called. In order to provide the user with a continuous source of chemical reagent it is desirable and customary to refill the bubbler or ampoule, which frequently is a smaller vessel, inside of the clean room from a larger reservoir contained outside of the clean room. The necessary piping and electronic controls are well known in the art for transfer of the chemical reagent from the reservoir to the bubbler via pressurization using an inert gas, e.g. nitrogen, by vacuum transfer techniques, or pumping systems.

In constructing a chemical refill system one of the problems is to accurately determine the level of the chemical reagent in the bubbler and in the reservoir so that transfers can be made at the proper time from the reservoir to the bubbler and the reservoir can be changed when it approaches being emptied.

In addition to the technique shown and described in U.S. Patent 4,859,375 a number of liquid level sensing technique have been tried in the industry with varying degrees of success.

A simple technique is weight sensing to determine the liquid level in the bubbler and/or the reservoir. Using a scale has the advantage of not requiring contact with the chemical reagent and can be independent of the type of vessel that is used to either store or dispense the chemical reagent. However, there are disadvantages in using scales for determining the level of the reagent and the various storage devices. To begin with there is a problem with small vessels, especially those made of stainless steel, that weigh more than the chemical that is contained inside of the vessel. For example, a scale to measure a kilogram (2.2 pounds) of chemical should be able to support a vessel weighing up to 7 kilograms (15.4 pounds) empty. Therefore, the difference between a full bubbler and an empty bubbler covers only 12.5% of the total available range of the scale reducing the total available signal and consequently scale resolution where the scale is electronic and incorporated into the control system. Furthermore, since the vessels must be weighed, and they are inter-connected via piping systems, the piping connections must be flexible to avoid the effect of the weight of the piping on the vessels.

Another technique involved using floating probes to measure the level of the liquid. A float made of polytetrafluoroethylene (Teflon) or stainless steel is immersed into the liquid (fluid). A magnetic reed switch is placed on the rod supporting the float, while a magnet is placed inside of the float, the magnet activating the reed switch. When the float comes within the vacinity of the switch the level of the liquid or reagent is indicated by an electronic circuit. The primary disadvantage of the float probe is that it immerses a moving object in the ultra pure fluid. This can produce some level of particulate contamination, although appropriate cleaning of the probe can minimize particulate shedding. In addition, a highly viscous material may cause the float to stick, preventing its use as a level sensing device. Lastly, the selection of probe material is important because it is immersed in the reagent and therefore must not react with it. Usually materials for the floats are carefully selected and the surfaces of the float are highly polished, with the float constructed to minimize the travel of the float so as to minimize the particulate formation problem.

Yet another technique involves using optical probes. A first type of optical probe involves using an optical sensor placed outside of a transparent vessel, e.g. a vessel made of quartz. An infrared light beam is passed through the vessel, and in the event liquid is present, it is refracted away from the detector. On the other hand if liquid is not present than the beam of light passes through the detector and a signal is created which alerts the user that the liquid has dropped below a required level. If the quartz bubbler has an imperfection in the wall, e.g. a dimple, this can cause light to be refracted away and a false reading given. Also, opaque liquids (a liquid that is opaque to the wavelength of light being used) will prevent operation of such a device. Reagents that are sensitive to changes in the presence of infrared light should not be exposed to such a device. Another optical technique uses a quartz probe immersed into the chemical. In this type of device the principal of total internal reflection is used. The light shines through the quartz striking a reflective surface that is precisely aligned to the Brewster angle of the probe. If liquid is present, most of the light will escape the probe, whereas if liquid is not present the light will mostly reflect back to the detector. This type of probe works well in theory but it has a number of practical drawbacks. The first is in the optical coupling of the photo transistor and light emitting diode ("LED") to the optical probe. Incorrect alignment and/or damage to the optical interface can prevent reliable operation. Another factor to be considered is the angle of the probe relative to the bottom of the reservoir, especially if the bottom of the reservoir is a highly polished surface. In this case false reflections can be sent back to the probe. Lastly, since the probe has to be in intimate contact with the fluid it must be installed in the vessel when it is manufactured before the chemical is placed into the vessel. This allows an opportunity for damage during manufacturing or shipping, which will result in total inoperativeness of this type of probe. Also optical probes must rely on a polymeric seal to join the quartz probe to a stainless vessel which provides an increase in leak potential and thus is not applicable to those vessels that require metal to metal seals.

Still another technique is to use electronic probes that generate an oscillating electromagnetic field called a "capacitive" technique. The probe is immersed into the fluid, and since the total capacitance and/or observed dielectric constant is based on the ratio of fluid to air in the vessel, sensitive electronics can be used to detect changes in the liquid level. These probes work well for many applications but calibration is very sensitive, since changes in the overall environment can change the system response. These probes require the use of insulation between the probe and the vessel, limiting its use in all-metal sealed vessels.

Ultrasonic probes have been developed for level sensing in a vessel, see for example, US-A-4,545,245. These type probes have historically been relatively large and expensive but they provide a number of advantages over other types of level sensing methods and have become more competitive in the past few years. Several types of ultrasonic probes exist. A first type is effectively a "sonar" for measuring the level and is designed for larger vessels than those that are typically used in the semiconductor industry. Levels are generally measured in feet from the sensor with a one foot minimum gap required. This type of sensor does not require immersion of the probe into the liquid. A second type of ultrasonic sensor contains a transmitter and receiver which are placed directly into the liquid via a probe. The probe transmits an ultrasonic signal. In the event no liquid is present between the transmitter and the receiver, very little sound is detected. When liquid is present the signal strength improves dramatically and the receiver can detect ultrasonic waves. A primary advantage of this technique is that the probe, though typically immersed in fluid has no moving parts and can use metal-to-metal seals. For most applications, ultrasonic techniques provide a reliable method for single point detection and can be used for level sensing when installed in the container sizes generally used in the semiconductor industry.

Another level sensing technique employs microwave pulses. However, these systems are very complex and very expensive and are not desirable for use in the semiconductor industry. These systems are currently used to measure distances in feet or meters and find particular application in large-scale applications, e.g. a 55 gallon reservoir, where there is a reasonable distance between the probe and the liquid surface.

Pressure differential sensors use the difference between the pressure at the top and the pressure of the bottom of a column of liquid. The primary drawback of this type of device is sensitivity to pressure transducer calibrations, which can drift through time.

Lastly, a technique for measuring chemical level involves the use of current flow through the chemical. In this application a very low voltage drives a low current through the fluid using a specialized circuit. Level sensing occurs when the voltage/current is picked up. This technique is fairly limited in application, working best with conductive and non-flammable chemicals. Suitable feedthroughs are required for use in an all-metal sealed system. This technique, as stated above requires that the material being measured is conductive and non-flammable.

Therefore, there is a need in the industry to have a reliable system for determining the level of a chemical reagent used in a semiconductor manufacturing operation so that the semiconductor manufacturing process is assured of having an adequate supply of chemical reagent continuously at the point of use.

### BRIEF SUMMARY OF THE INVENTION

The present invention pertains to a refill system that contains one or more large bulk containers, with one or more of the containers being used as a replaceable source of chemical reagent for a semiconductor manufacturing operation. The bulk container is connected to a receiver vessel that can be installed inside of the clean room or fab manufacturing area to serve as the source of supply of the selected chemical reagent at a point of use. The vessel may be configured to refill from one to the other in a reservoir to reservoir feed mode, or one or more reservoirs to a receiver vessel in an automatically switching mode, from one or more reservoirs in either of the two proceeding modes to one or more small vessels (e.g. bubblers), that work in either a vacuum vapor draw or carrier gas bubbling method, from one or more reservoirs in the preceding modes to a mass flow control or vaporization system, or from one or more of the bulk reservoirs into a large factory wide distribution manifold, the choice being dictated by the particular semiconductor fabrication operation.

Thus in one aspect the present invention is a system for providing chemical reagent by one of an ampoule or a direct liquid injection system to semiconductor processing reactors comprising a source reservoir for containing and dispensing ultrahigh purity chemical reagents, at least one receiver selected from the group consisting of an ampoule or a direct liquid injection system adapted to receive said reagent transferred from said source reservoir via a conduit system adapted to move said reagent from said source reservoir to said receiver, at least one multilevel ultrasonic probe inserted into said at least one receiver, and a separate probe inserted into said source reservoir for monitoring said level of reagent in said source reservoir, wherein, that at least one multilevel ultrasonic probe is either inserted into said at least one receiver or placed on an outside surface of said at least one receiver and is adapted to produce a first signal when said at least one receiver contains said reagent at a first level designated full, at a second level designating said at least one receiver as partially full and a third level designating said at least one receiver as requiring transfer of additional reagent from said source reservoir to said at least one receiver, and that said separate probe for monitoring said level of reagent in said source reservoir is a multilevel ultrasonic probe.

In another aspect the present invention entails the use of an ultrasonic level probe in the reservoir to determine when the reservoir requires additional reagent to be introduced into the reservoir from a remote source or to indicate when the reservoir must be replaced with a full reservoir.

In another aspect the present invention is a method for transferring chemical reagents from a reservoir to a remote receptacle via intermediate piping and transfer systems by incorporating an ultrasonic probe into the receiving vessel to determine precisely the level of chemical reagent in the receiving vessel, the ultrasonic probe being connected electronically to a control system to initiate a refill procedure from the reservoir to the receiving vessel when a certain level of reagent is detected in the receiving vessel and terminating flow of reagent from the reservoir to the receiving vessel when a second or full condition in the receiving vessel is detected.

In another aspect, the present invention includes methods for purging residual liquid from the inside of the delivery lines for use in replacing the source reservoir, and/or maintaining the delivery lines or internal system piping and valves, through the use of either vacuum cycle purging or through solvent cycle purging. A gas is delivered through a "cross-purge" valve and is used to push the residual chemicals from the internal delivery lines, back into the bulk reservoir. This area is then evacuated under vacuum with an optional inert gas feed. Generally, the vacuum pressure needs to be below the vapor pressure of the chemical being removed to effectively remove this chemical. The inert gas can help "sweep" this material out of the piping during the vacuum cycle. The pressure inside of the plumbing is monitored by the pressure gauge. When the chemical is fully removed, it is possible to identify this by noting the vacuum pressure as being equal to the base pressure of the plumbing when no chemical is present.

In a final aspect, the present invention is a method for precisely distributing chemical to a reactor chamber utilizing a direct liquid injection or similar vaporization or dispensing technique. The ultrasonic probe would be used to indicate to the chamber when chemical was available and whether replacing a source reservoir was required.

### BRIEF DESCRIPTION OF SEVERAL VIEWS OF THE DRAWINGS

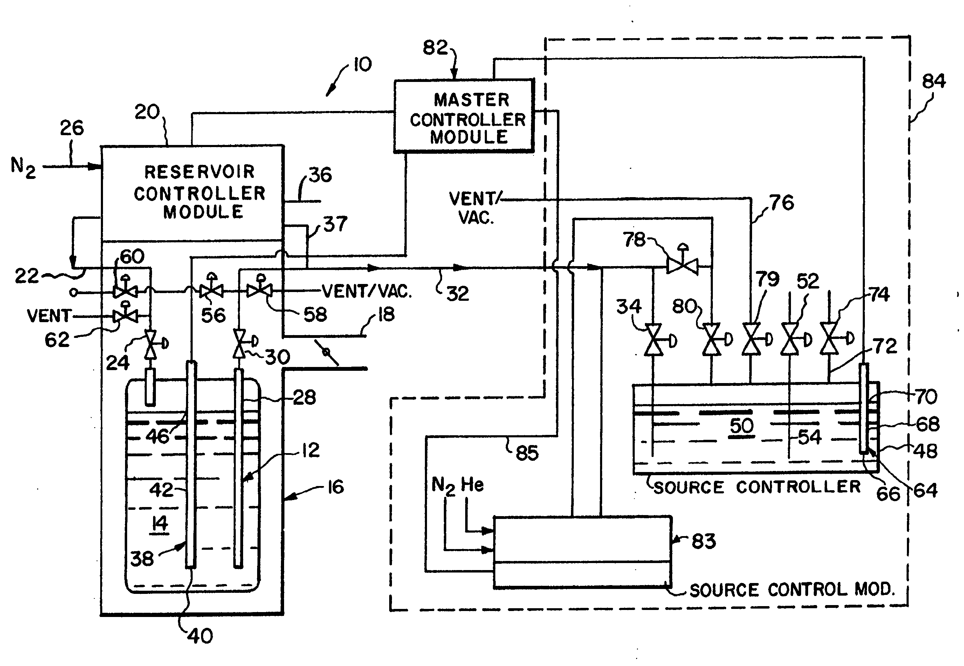

The single figure of the drawing is a schematic representation of a chemical refill system illustrating the method and apparatus of the present invention.

### DETAILED DESCRIPTION OF THE INVENTION

Referring to the drawing the system 10 includes a reservoir 12 which contains a reagent chemical 14. The reservoir 12 can be contained within a housing or cabinet 16 to contain any leakage from the reservoir 12. Housing 16 contains a vent system shown generally as 18 to evacuate the housing 16 of reagent vapors, and a reservoir controller module 20, the construction and operation of which are well known in the art. Reservoir 12 has an inlet conduit 22 with a control valve 24 to admit a source of inert gas, e.g. nitrogen to the reservoir to pressurize the reservoir 12. Nitrogen or other carrier gas is . introduced into the reservoir 12 through valves contained in the controller module 20 which receives the carrier gas through conduit 26. Reservoir 12 includes an outlet conduit 28 with a control valve 30 to deliver reagent through a connecting conduit 32 through a second control valve 34 to a bubbler or ampoule 48.

Disposed within the reservoir 12 is a level sensing device 38 such as manufactured and sold by Cosense Inc. of Hauppauge, New York. The sensing device 38 may include a single ultrasonic sensor disposed at the lower end 40 of the device 38 to indicate when the reservoir is empty or may have level sensors disposed at an intermediate level 42 and an upper level 46 to indicate the presence of liquid at a full condition (location 46) or intermediately full position (level 42). Alternatively the ultrasonic sensor 38 can have an indefinite number of ultrasonic sensors to detect varying levels of reagent in the reservoir 12. The use of a continuous level sense probe to provide these multiple levels in the reservoir provides equivalent results.

Conduit or pipe 36 enters reservoir controller module 20 and passes through a control system so that an inert gas, e.g. nitrogen can be introduced into conduit 32 via conduit 37 to purge the delivery conduits or piping of reagent.

The plumbing or piping system associated with the reservoir 12, housing 16 and reservoir controller module 20 also includes a set of valves and piping for purging. A valve 56 is used to isolate the high pressure push gas side of the piping system from the liquid containing side, and permits inert gas flow to occur that can push the liquid chemical back into the reservoir. Valve 58 is used to initiate the vacuum cycle permitting vacuum cycle purging. Valve 60 is used to isolate the pressure gauge and prevent its damage or loss of calibration during cycle purge and other operations. Valve 62 is a vent valve, used to vent excess pressure from the system during maintenance and line purging operations.

The ampoule or bubbler 48 includes a reservoir of reagent chemical 50 and an inlet conduit 54 to admit a carrier gas such as nitrogen or helium into the bubbler 48 via control valve 52 and conduit 54. The bubbler or ampoule 48 includes an ultrasonic level sensing device 64 of the type manufactured and sold by Cosense Inc., the company referred to above. As with the level sensing device in reservoir 12 the level sensing device 64 in bubbler 48 can have one ultrasonic device at the bottom 66 to detect an empty condition inside the bubbler or ampoule 48. However, this is not generally acceptable, since reagent should be transferred from the reservoir 12 to the bubbler 48 before the level of liquid at 66 is reached. Therefore, the level sensing device 62 can have one or more intermediate level indicators 68 and a full level indicator 70. Ampoule or bubbler 48 includes an outlet conduit 72 and control valve 74 for dispensing reagent and a carrier gas to the point of use in the process reactor. A vent conduit 76 and vent control valve 79 are included in the bubbler or ampoule 48 (source container system) to permit venting of reagent vapors in a safe manner, as is well known in the art. Valves 78 and 80 are included in the source container system for the purpose of purging the system with an inert gas or by vacuum, as is well known in the art.

The system 10 can include a master controller module 82, the master controller module 82 being connected electrically and via suitable plumbing connections to both the reservoir 12 and the bubbler 48 as is well known in the art. It is also possible to use a source control module 83 which is electrically connected to the master controller 82 via line 85. For example, ultrasonic level sensing according to the present invention may be adapted to chemical refill systems for sale by the Schumacher unit of Air Products and Chemicals, Inc. Carlsbad California.

According to the present invention when the system is connected as shown and the level sensing devices are placed as shown, when a signal is received by the master controller module 82 from the level sensing device 64, be it at level 66 or level 68 or some level intermediate of level 66 and level 68, the proper valves are opened to force reagent 14 from the reservoir 12 to the bubbler 48. One way of accomplishing this is to pressurize the reservoir 12 using nitrogen introduced through valve 24 and conduit 26. Alternatively the system 10 can be set-up to be a vacuum draw system where a vacuum is created in the head space in the bubbler 48 and valves 30, 34 are opened in order to draw a reagent from the reservoir 12 to bubbler 48. Alternatively, the chemical may be pushed form reservoir 12 to a direct liquid injection or similar dispense unit in a downstream tool.

As it is well known in the art the bubbler at 48 and certain of the piping and controls can be contained within the clean room indicated by box 84. The reservoir 12 and the associated piping can be contained outside of the clean room 84 so that the reservoir 12 can be replaced without the necessity of a person entering the clean room to refill the bubbler and thus the semiconductor Fab clean room is not compromised.

The refill system 10 consist of a control system that may consist of a set of logic gates, a programmable logic controller, or a microprocessor based computer of many known types. Each of these types of control systems is functionally equivalent as long as the functions of the controllers are properly executed. In addition a plumbing manifold provides the ability to push ultrapure chemical out of the reservoir 12 with the use of a pressurized gas, or alternatively, by using a pumping or a vacuum draw system. The manifold needs to provide access for the pressurizing or pushing gas, an exit point for the chemical to exit the vessel, a valve to allow venting of excess pressure from the reservoir, a valve to provide a vacuum source for purging the manifold (which could include the vent valve previously mentioned), and a cross purge valve for connecting the liquid and gas pressure sides of the manifold for purging purposes. Other valves and piping may be installed to prevent isolation of various sensors, including vacuum and gas pressure, alternative level sensing techniques and the like, all of which are known and some of which are currently employed.

In the case of a reservoir to reservoir feed mode, valves and piping must be present to permit the ultrapure chemical to enter the receiving vessel, as well as to exit the vessel for distribution to a process tools further down stream. In this case, both vessels need to have independent means of purge and removal, although that is not a strict process requirement, but is based on minimizing the down time and impact of reservoir replacement.

In the case of an autoswitching feed mode, valves and piping must be present to permit the reservoirs to alternatively run chemical from one reservoir to another without impacting the process in the one that is not currently active. The inactive reservoir(s) need to have independent means of purge and removal, although that is not a strict process requirement but is based on minimizing the down time impact of reservoir replacement.

In the case of feeding a receiving vessel residing in a process tool, means must be provided to permit delivery of the chemical into the tool, to permit the flow of chemical into the receiving vessel with adequate venting and/or pressure control to prevent back streaming or other adverse process conditions, as well as the means for purging the manifold for replacing the receiving vessel in the event of contamination or damage.

In the case of feeding a process tool directly via direct liquid injection, or feeding a broad area distribution manifold, the manifold needs to be designed to maintain constant pressure to the manifold at all times. This is typically performed through the use of a combination of standard pressure regulators, and back pressure regulators, or pressure relief valves of various types. All of these are functionally equivalent as long as the process line pressure stays stable within specified ranges.

The plumbing manifold may be constructed of either Teflon, stainless steel, Inconel, Hastalloy, titanium, or inert lined components, such as stainless steel coated with Teflon or coated with SiO2, depending on the corrosivity of the materials being delivered. In the case of tetraethylorthosilicate ("TEOS") and associated dopants, AISI type 316L stainless steel is recommended, in the case of 1,2-transdichloroethylene and other more corrosive sources, Teflon is the material of choice. Other chemicals that may be run in the refill system with suitable plumbing are compounds, such as CupraSelect, i.e., cuprous hexafluoroacetylacetonate trimethylvinylsilane ("Cu(hfac)(TMVS)"), cupric bis(hexafluoroacetylacetonate) ("Cu(hfac)2"), tantalum tetraethoxide ("TAETO"), tetrakis(diethylamino)titanium ("TDEAT"), tetrakis(dimethylamino)titanium ("TDMAT"), dimethylaluminumhydride ("DMAH") and similar aluminum precursors; alternative silicon dioxide, silicon nitride and fluorinated silicon dioxide sources, such as fluorotriethoxysilane ("FTES"), bis(tertiarybutyl)aminosilane ("BTBAS"), diethylsilane and related types of compounds; mixtures of solid precursors dissolved in solvents, such as boron strontium titanate ("BST") precursor materials; solid materials that are liquefied or sublimated in situ by heating the reservoir or refill system cabinet; process solvents and cleaning agents including hexafluoroacetylacetone ("Hfac"), trimethylvinylsilane ("TMVS"), toluene, hexane, nitric acid, hydrofluoric acid, and related compounds, including neutralizing agents; solvents for photomasking operations, including edge bead removal chemicals such as ethyl lactate, and developer solutions, chemical mechanical polishing slurries, spin on materials for use as precursors for spin-on glass, spin-on dopant, and spin-on metal precursors, triethylborate ("TEB"), trimethylborate ("TMB"), trimethylphosphite ("TMPI"), trimethylphosphate ("TMPO"), 1,1,1-trichloroethane ("TCA"), polypropylene glycol monomethylether acetate ("PGMEA") and all other liquid chemical precursors and dopants that are related to chemical vapor deposition ("CVD") photoresist and developer and diffusion operations.

The reservoir can be housed in a cabinet that contains the control systems, local manifolds, safety options, such as spill containment, fire detection and suppression, vapor and spill detection, and any required heating systems to liquefy, reduce viscosity or sublimate precursor materials that reside within the process reservoirs.

Level sensing according to the present invention utilizes ultrasonic energy to determine the position of the chemical. In one embodiment, the ultrasonic probes consist of ultrasonic transmitters that are enclosed in a steel or Teflon jacket that transmit energy in the event liquid is present, and do not transmit energy in the event liquid is no longer present. The transmission of the energy is detected by a suitable sensor also mounted in the steel or Teflon jacket. The detection of the energy causes electrical changes that are transmitted through a cable into the control system. This detection system is called a "discrete" system, since each level is uniquely identified with the use of one pair of transmitter/detectors. Multiple transmitter/detector pairs can be installed in the steel or Teflon jacket to provide multiple levels of chemical to be detected.

In another embodiment, an ultrasonic sensor that sends waves of energy into a rod or into the container walls can be utilized. In this case, the transmitter and receiver are mounted on either the outer or inner surface of the reservoir. The transmitter emits a signal, and it is then reflected back to the detector after striking the liquid level surface. The level of the fluid can be determined either through determining the time delay between the transmission and the reflection, or by monitoring phase shifts of the reflecting signal, and may include the use of multiple frequency ultrasonic transmissions to reduce variability. This system is called a "continuous" level sense, and provides data on the level of the chemical in an analog fashion, as opposed to the discrete method described above. Both techniques are functionally equivalent in this application.

The ultrasonic level sense of the present invention is used in a variety of ways, depending on the application.

The first application is to use two or more sensors in a reservoir with a low level sensor to indicate when a replacement reservoir needs to be changed, a warning low level sensor to indicate that the reservoir is nearly empty. A third level sense can be used at the top of the reservoir to indicate that the vessel has been overfilled. This upper level probe can alternatively be used to indicate cable damage or cable disconnect. A single sensor can be used to indicate empty only, but is generally discouraged by industry, since this provides no warning that the vessel is about to run empty. This application setup can be used in either a supply reservoir or in a receiving reservoir.

The second application uses three or more sensors in a receiving reservoir or vessel that requires being filled to a specific level. In this case, an overfill sensor is placed at the very top of the probe, a "fill stop" sensor is placed at the maximum specified level, frequently around 70% full, a "fill start" sensor is placed at the minimum specified level, frequently around 40-60% a "low" or "empty" sensor placed below the "fill start" location to indicate the reservoir is well below specified values, indicating a failure of some sort, and optionally, a "completely empty" sensor to indicate that the reservoir has drained completely. This might be used when removing a reservoir for maintenance or cleaning.

The third application uses multiple sensors in a system that contains solid or highly viscous precursors. In this application, float probes, optical and capacitive probes do not work efficiently, while ultrasonic probes can be adjusted to work rather well. In addition, the vessels or refill system cabinet may be heated to permit the delivery of either liquid precursor, or sublimated solid precursors. The level sense will work in a manner similar to the first or second applications within the constraints of the process tool that is being replenished. Some examples of materials that fall into this category include Cu(Hfac)2, TAETO, DMAH, and many BST, and similar precursor materials.

The size of the vessel has no effect on the method and apparatus of the present invention. Receiving and source reservoirs may range in size, with 200 liter nominal, 20 liter nominal, 10 liter nominal, 1.5 to 3 liter nominal, and 0.5 liter nominal sizes being typical. The vessel itself may be constructed of 316L stainless steel, quartz, Teflon, or other material inert to the process chemical in question, and may be lined with another material to reduce the reactivity of the bulk chemical and the vessel walls.

Continuous ultrasonic level sense can be used to meet the requirements dictated by the size, shape and material of construction of the vessel, simply by setting the various setpoints in software or hardware within the control electronics.

The operation of the refill system is fairly straightforward. When the receiving vessel reaches a low level or fill start condition, the ultrasonic level sense probe status changes. This is picked up by the control electronics that then initiates a valve sequence on the supply reservoir to permit filling of the receiver vessel. The control system observes the condition of the fill stop sensor, and when it transitions to a liquid present state, the control system closes the valves to stop the filling process. In the event of a failure of the fill stop sensor, the overfill sensor will eventually be reached, and in the event that it detects liquid, the system fill function is stopped. This operation continues until the source reservoir indicates a low or empty signal. When this occurs, the control system generates an alarm, and the operator can select when they wish to provide a reservoir change. In the event of the auto-switching mode described above, the control system will automatically initiate the filling procedure using the second or subsequent reservoir in line while the supply reservoir is replaced.

Thus, the present invention is an improvement over known chemical refill systems in that the conventional techniques for signaling the transfer of reagent from the reservoir to the bubbler or ampoule are replaced by an ultrasonic level sensing device. The ultrasonic level sensing device has no moving parts. There is no compromise of the chemical from moving parts being contained in a level sensing system as there are with many of the prior art techniques noted above. In addition, the ultrasonic level sensing device has improved reliability and requires no specialized plumbing. The ultrasonic level sensing control system is more reliable then optical probes and provides clean, non-moving discrete or continuous data regarding the level of the ultrapure chemical. It removes sources of particle generation, improves reliability and maintainability of the probe and the overall system. In addition, this technique works better than any of the others in the use of high viscosity source materials. In these case, float probes stick, and optical and capacitive probes fail due to chemical adhesion on their surfaces.

It is within the scope of the present invention to use inert gas purging, vacuum cycle purging and solvent purging to remove residual process reagents from the storage and delivery system.

Therefore, to the user of the reagent there are a number of benefits. Most importantly is the constant maintenance of the purity of the reagent chemical. In addition there is a reliable determination of the level of reagent in both the reservoir and the bubbler or ampoule and the precise timing of the transfer of reagent from the reservoir to the bubbler.

## Claims

1. A system (10) for providing chemical reagent by one of an ampoule (48) or a direct liquid injection system to semiconductor processing reactors comprising
a source reservoir (12) for containing and dispensing ultrahigh purity chemical reagents (14),
at least one receiver (48) selected from the group consisting of an ampoule or a direct liquid injection system adapted to receive said reagent transferred from said source reservoir (12) via a conduit system (32) adapted to move said reagent from said source reservoir (12) to said at least one receiver (48),
at least one multilevel ultrasonic probe (64) inserted into said at least one receiver (48), and
a separate probe (38) inserted into said source reservoir (12) for monitoring said level of reagent (14) in said source reservoir (12),
**characterized in, that**
at least one multilevel ultrasonic probe (64) is either inserted into said at least one receiver (48) or placed on an outside surface of said at least one receiver (48) and is adapted to produce a first signal when said at least one receiver (48) contains said reagent at a first level (70) designated full, at a second level (68) designating said at least one receiver (48) as partially full and a third level (66) designating said at least one receiver (48) as requiring transfer of additional reagent from said source reservoir (12) to said at least one receiver (48), and that
said separate probe (38) for monitoring said level of reagent (14) in said source reservoir (12) is a multilevel ultrasonic probe (38).

2. A system (10) according to claim 1, wherein said ultrasonic probe (64) is electrically connected to a control system (20, 82) including means to transfer reagent (14) from said reservoir (16) to said receiver (48) in response to a signal generated by said ultrasonic probe (64).

3. A system according to claim 2, wherein said signal corresponds to a level of reagent in said receiver (64) above said third level of said ultrasonic probe (64).

4. A system according to claim 1 including means (26, 20, 22, 24) to introduce an inert gas (N₂) into said source reservoir (16) to pressurize said source reservoir (16) to cause said reagent (14) to transfer from said source reservoir (16) to said receiver (48).

5. A system according to claim 1 including means for purging said residual process reagent from the delivery/feed lines using one of vacuum cycle purging or solvent purging to effect reagent removal.

6. A system according to claim 1 including means (20, 82) to automatically operate valves operated through one of pneumatic or electrical actuators.

7. A system according to claim 6 wherein said valves operate from computer generated signals sent to a valve actuator.

8. A system according to claim 4, wherein said means to introduce an inert gas (N₂) into said source reservoir (12) can be adapted to introduce said inert gas (N₂) into said receiver (48) to act as a carrier gas.

9. A system according to claim 1, wherein said ultrasonic probe is disposed either in said source reservoir (12), or placed on an outside surface of said reservoir (12) to determine the level of chemical reagent (14) in said source reservoir (12).

10. A system according to claim 1 including at least one ampoule (48) with multilevel ultrasonic detectors (68) as said receiver (48) connected to said source reservoir (12).

11. A system according to claim 1 including means to create a partial vacuum in said receiver (48) to cause chemical reagent (14) to move from said source reservoir (12) to said receiver (48), or to create positive pressure on said source reservoir (12) to effect the reagent transfer.

12. A system according to claim 1, wherein said receiver (48) is a direct liquid injection system to provide reactive vapor to said processing reactor.

13. A system according to claim 12 including a plurality of ampoules (48), each with ultrasonic multilevel detectors as said receiver (48) connected to said source reservoir (12).

14. A system according to claim 1, wherein said receiver (48) is an ampoule and includes either means to create a partial vacuum in said ampoule to cause chemical reagent to move from said ampoule (48) to a semiconductor processing reactor, or means to supply positive pressure to the source reservoir (12) to cause chemical reagent transfer.

15. A system according to claim 11 including means to pressurize said source reservoir (12) with an inert gas (12) to force reagent (14) to move to one of a direct liquid injection system or liquid mass flow controllers.

16. A system according to claim 1 adapted for the refilling of chemical reagent (14) selected from the group consisting of TEOS, TEB, TMB, TMPI, TMPO, Cu(hfac)(TMVS) and its various blends, TDEAT, TDMAT, TiCl4, DCE, TCA, POCl3, BBr3, PCl3, TAETO, BTBAS, BST precursors dissolved in carrier solvents, solid materials requiring liquifaction such as Cu(hfac)2, PGMEA, Ethyl Lactate, all other liquid chemical precursors and dopants that are related to CVD, photoresist and developer, and diffusion operations.

17. A system according to claim 1, wherein the materials of construction for the system are selected from the group consisting of stainless steel, Teflon, Inconel, Hasteloy, quartz, glass, plastic and other materials that are not reactive with the chemical reagent (14) to be used in the system.

18. A method for transferring chemical reagent (14) from a source reservoir (12) to a receiver (48) for a semiconductor processing reactor contained inside a clean room in a semiconductor fabrication facility utilizing a source reservoir (12) for holding a bulk quantity of said reagent (14), one or more receivers (48) from which said reagent is dispensed to produce an effect on a semiconductor substrate, transfer piping (32) between said reservoir (12) and said receiver (48), a control system (20, 82) including means to sense liquid levels inside said source reservoir (12) and said receiver (48), **characterized by**:
at least one ultrasonic probe (38) at the inside of said reservoir (12) or placed on an outside surface of said reservoir (12) produces a signal when a level of reagent (14) in said reservoir (12) is reached that indicates said reservoir needs refilling of said reagent or replacement with a full reservoir (12);
said signal is conducted to said control system (82) to activate one of, an alarm signal, an indicator light, or a digital readout to alert a user to attend to said reservoir;
an ultrasonic probe (64) in said receiver (48) produces a signal when a level of reagent (14) in said receiver (48) is reached that indicates said receiver needs to be refilled with said chemical reagent (14); and
said signal from said ultrasonic probe (64) in said receiver (48) is used to cause transfer of said chemical reagent (14) from said reservoir (12) to said receiver (48).

19. A method according to claim 18, wherein a multilevel ultrasonic probe (38) inside said source reservoir (12) produces signals indicating one of three levels of liquid reagent (14) inside said reservoir (12), said levels being a first or full level, a second or partially full level and a level where the reservoir (12) needs to be refilled or replaced.

20. A method according to claim 18, wherein a multilevel ultrasonic sensing probe (64) in each of said receivers (48) produces separate signals indicating a condition inside said receiver (48) being one of, having a level of liquid reagent indicating said receiver (48) is full, having a level of liquid indicating said receiver (48) needs liquid reagent transferred from said source reservoir (12) to said receiver (48), and a level of liquid reagent indicating said receiver (48) contains a level of liquid between full and requiring transfer of liquid reagent from said source reservoir (12) to said receiver (48), and wherein said signals are conducted to said control system (20, 82) to activate one or all of an alarm signal, indicator lights corresponding to the liquid reagent level in said receiver (48), digital readouts of the level of liquid reagent in said receiver (48) and transfer of liquid reagent (14) from said source reservoir (12) to said receiver (48).

21. A method according to claim 20, wherein said signals are used to set said control system (20, 82) to automatically initiate transfer of liquid reagent (14) from said source reservoir (12) to said receiver (48) when a pre-selected low level of liquid reagent is sensed in said receiver (48) and to terminate transfer of liquid reagent when said full level is sensed in said receiver (48).

22. A method according to claim 18, wherein one of a direct liquid injection system or a dispensing system is installed as said receiver (48).

## Patentansprüche

1. System (10), um chemisches Reagenz durch eine Ampulle (8) oder ein direktes Flüssigkeits-Injektionssystem Halbleiter-Verarbeitungsreaktoren zur Verfügung zu stellen,
mit einem Quellenreservoir (12), das chemische Reagenzien (14) von ultrahoher Reinheit enthält und verteilt,
wenigstens einem Empfänger (48), der aus der Gruppe ausgewählt ist, die aus einer Ampulle oder einem direkten Flüssigkeits-Injektionssystem besteht, die bzw. das angepasst ist, um das Reagenz zu empfangen, das von dem
Quellenreservoir (12) über ein Leitungssystem (32) überführt wird, das angepasst ist, um das Reagenz von dem Quellenreservoir (12) zu dem wenigstens einem Empfänger (48) zu überführen,
wenigstens einer Ultraschallsonde (64) mit mehreren (Meß-)Pegel, die in den wenigstens einen Empfänger (48) eingeführt wird, und
mit einer getrennten Sonde (38), die in das Quellenreservoir (12) eingeführt wird, um den Pegel des Reagenz (14) in dem Quellenreservoir (12) zu überwachen,
**dadurch gekennzeichnet, dass**
wenigstens eine Ultraschall-Sonde (64) mit mehreren (Meß-)Pegel entweder in den wenigstens einen Empfänger (48) eingeführt oder an einer Außen-Oberfläche des wenigstens einen Empfängers (48) angeordnet und angepasst ist, um ein erstes Signal zu erzeugen, wenn der wenigstens eine Empfänger (48) das Reagenz an einem ersten Pegel (17), der den Füllstand "voll" kennzeichnet, an einem zweiten Pegel (68), der den wenigstens einen Empfänger (48) als "teilweise voll" kennzeichnet, und einem dritten Pegel (66) enthält, der angibt, dass für den wenigstens einen Empfänger (48) die Überführung von zusätzlichem Reagenz von dem Quellen-Reservoir (12) zu dem wenigstens einen Empfänger (48) erforderlich ist, und dass
die getrennte Sonde (38) zur Überwachung des Pegels des Reagenz (14) in dem Quellenreservoir (12) eine Ultraschall-Sonde (38) mit mehreren (Meß-) Pegeln ist.

2. System (10) nach Anspruch 1, wobei die Ultraschall-Sonde (64) elektrisch mit einem Steuersystem (20, 82) mit einer Anordnung zum Transportieren des Reagenz (14) von dem Reservoir (16) zu dem Empfänger (48) in Abhängigkeit von einem Signal verbunden ist, das von der Ultraschall-Sonde (64) erzeugt wird.

3. System nach Anspruch 2, wobei das Signal einen Pegel des Reagenz in dem Empfänger (64) über dem dritten Pegel der Ultraschall-Sonde (64) entspricht.

4. System nach Anspruch 1 mit einer Anordnung (26, 20, 22, 24) zur Einführung eines Inertgases (N₂) in das Quellen-Reservoir (16), um das Quellen-Reservoir (16) unter Druck zu setzen, so dass das Reagenz (14) von dem Quellen-Reservoir (16) zu dem Empfänger (48) überführt wird.

5. System nach Anspruch 1 mit einer Anordnung zum Spülen von restlichem Verfahrens-Reagenz aus den Liefer-/Zuführleitungen unter Verwendung eines Unterdruck-Spülzyklus oder einer Lösungsmittelspülung, um die Entfernung des Reagenz durchzuführen.

6. System nach Anspruch 1 mit einer Anordnung (20, 82) zur automatischen Betätigung von Ventilen, die durch pneumatische oder elektrische Stellgliedern betätigt werden.

7. System nach Anspruch 6, wobei die Ventile durch computer-erzeugte Signale betätigt werden, die zu einem Ventil-Stellglied gesandt werden.

8. System nach Anspruch 4, wobei die Einrichtung zur Einführung eines Inertgases (N₂) in das Quellenreservoir (12) angepasst werden kann, um das Inertgas (N₂) in den Empfänger (58) einzuführen, um als Trägergas zu wirken.

9. System nach Anspruch 1, wobei die Ultraschall-Sonde entweder in dem Quellenreservoir (12) angeordnet oder auf einer Außen-Oberfläche des Reservoirs (12) angeordnet ist, um den Pegel des chemischen Reagenz (14) in dem Quellenreservoir (12) zu bestimmen.

10. System nach Anspruch 1 mit wenigstens einer Ampulle (48) mit mehreren Ultraschall-Detektoren (68) mit mehreren (Meß-)Pegeln als der Empfänger (48), der mit dem Quellen-Reservoir (12) verbunden ist.

11. System nach Anspruch 1 mit einer Einrichtung zur Erzeugung eines Unterdrucks bzw. teilweisen Vakuums in dem Empfänger (48), so dass chemisches Reagenz (14) von dem Quellenreservoir (12) zu dem Empfänger (48) transportiert wird, oder um einen Überdruck auf dem Quellenreservoir (12) zu erzeugen, um die Überführung des Reagenz zu bewirken.

12. System nach Anspruch 1, wobei der Empfänger (48) ein direktes Flüssigkeits-Injektionssytem ist, das dem Verarbeitungsreaktor reaktiven Dampf zur Verfügung stellt.

13. System nach Anspruch 12 mit mehreren Ampullen (48), von denen jede mit Ultraschall-Detektoren mit mehreren (Meß-)Pegeln als der Empfänger (48) ausgestaltet ist, der mit dem Quellen-Reservoir (12) verbunden ist.

14. System nach Anspruch 1, wobei der Empfänger (48) eine Ampulle ist und entweder eine Einrichtung zur Erzeugung eines Unterdrucks bzw. eines teilweisen Vakuums in der Ampulle, um den Transport des chemischen Reagenz von der Ampulle (48) zu dem Halbleiter-Verarbeitungsreaktor zu bewirken, oder eine Anordnung zur Anlegung eines Überdrucks an das Quellenreservoir (12) enthält, um die Überführung des chemischen Reagenz zu bewirken.

15. System nach Anspruch 11 mit einer Anordnung, um das Quellenreservoir (12) mit einem Inertgas (12) unter Druck zu setzten, so dass das Reagenz (14) entweder zu einem direkten Flüssigkeits-Injektionssystem oder zu Controllern für den Flüssigkeits-Massenstrom transportiert wird.

16. System nach Anspruch 1, das angepasst für das Nachfüllen von chemischem Reagenz (14) ist, das aus der Gruppe ausgewählt wird, die aus TEOS, TEB, TMB, TMPI, TMPO, Cu(hfac) (TMVS) und aus ihren verschiedene Mischungen, TDEAT, TDMAT, TiCl4, DCE, TCA, POCl3, BBr3, PCl3, TAETO, BTBAS, BST Precursern, die in Trägerlösungsmitteln gelöst sind, wobei die Feststoffe eine Verflüssigung erfordern, wie beispielsweise Cu(hfac)2, PGMEA, Ethyl Lactat, allen andren flüssigen chemischen Precursern und Dotierungsmittel bestehen, die zu CVD, Photoresist und Entwickler sowie Diffusionsoperationen gehören.

17. System nach Anspruch 1, wobei die Konstruktionsmaterialen für das System aus der Gruppe ausgewählt sind, die aus rostfreiem Stahl, Teflon, Inconel, Hasteloy, Quartz, Glas, Kunststoff und anderen Materialen bestehen, die nicht mit dem chemischen Reagenz (14) reagieren, das in dem System verwendet werden soll.

18. Verfahren zur Überführung eines chemischen Reagenz (14) von einem Quellen-Reservoir (12) zu einem Empfänger (14) für einen Halbleiter-Verarbeitungsreaktor, der im Innern eines Reinraums in einer Halbleiter-Fertigungsanlage enthalten ist, die ein Quellen-Reservoir (12) zum Aufnehmen einer Bulk Menge des Reagenz (14), einen oder mehrere Empfänger (48), von denen das Reagenz ausgeteilt wird, um eine Wirkung auf ein Halbleitersubstrat zu erzeugen, Transportrohrleitungen (32) zwischen dem Reservoir (12) und dem Empfänger (58), ein Steuersystem (20, 82) mit einer Anordnung zum Erfassen der Flüssigkeitspegel im Innern des Quellenreservoirs (12) und des Empfängers (48) verwendet,
**gekennzeichnet durch**:
wenigstens eine Ultraschall-Sonde (38) an der Innenseite des Reservoirs (12) oder angeordnet auf einer äußeren Oberfläche des Reservoirs (12) erzeugt ein Signal, wenn der Pegel des Reagenz (14) in dem Reservoir (12) erreicht wird,
der anzeigt, dass das Reservoir mit dem Reagenz nachgefüllt oder **durch** ein volles Reservoir (12) ersetzt werden muss;
das Signal wird zu dem Steuersystem (82) geleitet, um ein Alarmsignal, ein Anzeigelicht oder eine digitale Anzeige zu betätigen, um den Benutzer darauf hinzuweisen, dass das Reservoir gewartet werden muss;
eine Ultraschall-Sonde (64) in dem Empfänger (48) erzeugt ein Signal, wenn ein Pegel des Reagenz (14) in dem Empfänger (48) erreicht wird, der anzeigt, dass der Empfänger mit dem chemischen Reagenz (14) aufgefüllt werden muss; und das Signal von der Ultraschall-Sonde (64) in dem Empfänger (48) wird dazu verwendet, um die Überführung des chemischen Reagenz (14) von dem Reservoir (12) zu dem Empfänger (48) zu bewirken.

19. Verfahren nach Anspruch 18, wobei eine Ultraschall-Sonde (38) mit mehreren (Mess-)Pegeln im Innern des Quellen-Reservoirs (12) Signale erzeugt, die einen von drei Pegeln des flüssigen Reagenz (14) im Innern des Reservoirs (12) angeben, wobei die Pegel ein erster oder Pegel "voll", ein zweiter oder Pegel "teilweise voll" und ein Pegel sind, bei dem das Reservoir (12) nachgefüllt oder ersetzt werden muss.

20. Verfahren nach Anspruch 18, bei dem eine Ultraschall-Messsonde (64) mit mehreren (Mess-)Pegeln in jedem der Empfänger (48) getrennte Signale erzeugt, die den Zustand im Innern des Empfängers (48) angeben, und zwar für einen Pegel des flüssigen Reagenz, der angibt, dass der Empfänger (48) "voll" ist, einen Pegel der Flüssigkeit, die angibt, dass flüssiges Reagenz von dem Quellenreservoir (12) zu dem Empfänger (48) überführt werden muss, und einen Pegel des flüssigen Reagenz, der angibt, dass der Empfänger (48) einen Pegel der Flüssigkeit zwischen "voll" und dem Pegel hat, der die Überführung des flüssigen Reagenz von dem Quellen-Reservoir (12) zu dem Empfänger (48) anzeigt, und wobei die Signale zu dem Steuersystem (20, 82) geleitet werden, um eins oder alle eines Alarmsignals, Anzeigeleuchten, die dem Pegel des flüssigen Reagenz in dem Empfänger (48) entsprechen, digitale Anzeigen des Pegels des flüssigen Reagenz in dem Empfänger (48) und die Überführung des flüssigen Reagenz (14) von dem Quellen-Reservoir (12) zu dem Empfänger (48) betätigen.

21. Verfahren nach Anspruch 20, wobei die Signale verwendet werden, um das Steuersystem (20, 82) so einzustellen, dass die Überführung des flüssigen Reagenz (14) von dem Quellen-Reservoir (12) zu dem Empfänger (48) automatisch eingeleitet wird, wenn ein vorher ausgewählter niedriger Pegel des flüssigen Reagenz in dem Empfänger (48) festgestellt wird, und die Überführung des flüssigen Reagenz beendet wird, wenn der Pegel "voll" in dem Empfänger (48) detektiert wird.

22. Verfahren nach Anspruch 19, wobei ein direktes Flüssigkeits-Injektionssystem oder ein Ausgabesystem als Empfänger (48) installiert wird.

## Revendications

1. Système (10) destiné à fournir un réactif chimique au moyen d'une ampoule (48) ou d'un système d'injection directe de liquide à des réacteurs de traitement de semi-conducteurs, comprenant :
un réservoir source (12) pour contenir et distribuer des réactifs chimiques de très haute pureté (14),
au moins un récepteur (48) choisi parmi le groupe comprenant une ampoule ou un système d'injection directe de liquide propre à recevoir ledit réactif transféré dudit réservoir source (12) via un système de conduit (32) propre à déplacer ledit réactif dudit réservoir source (12) vers ledit au moins un récepteur (48),
au moins une sonde ultrasonore multiniveaux (64) insérée dans ledit au moins un récepteur (48), et
une sonde séparée (38) insérée dans ledit réservoir source (12) pour surveiller ledit niveau de réactif (14) dans ledit réservoir source (12),
**caractérisé en ce que**
au moins une sonde ultrasonore multiniveaux (64) est soit insérée dans ledit au moins un récepteur (48), soit placée sur une surface extérieure dudit au moins un récepteur (48) et est propre à produire un premier signal lorsque ledit au moins un récepteur (48) contient ledit réactif à un premier niveau (70) désigné comme plein, à un deuxième niveau (68) désignant ledit au moins un récepteur (48) comme partiellement plein et un troisième niveau (66) désignant ledit au moins un récepteur (48) comme nécessitant le transfert de réactif supplémentaire à partir dudit réservoir source (12) vers ledit au moins un récepteur (48), et **en ce que**
ladite sonde séparée (38) pour surveiller ledit niveau de réactif (14) dans ledit réservoir source (12) est une sonde ultrasonore multiniveaux (38).

2. Système (10) selon la revendication 1, dans lequel ladite sonde ultrasonore (64) est connectée électriquement à un système de commande (20, 82) comprenant des moyens pour transférer le réactif (14) dudit réservoir (16) vers ledit récepteur (48) en réponse à un signal généré par ladite sonde ultrasonore (64).

3. Système selon la revendication 2, dans lequel ledit signal correspond à un niveau de réactif dans ledit récepteur (64) au-dessus dudit troisième niveau de ladite sonde ultrasonore (64).

4. Système selon la revendication 1 , comprenant des moyens (26, 20, 22, 24) pour introduire un gaz inerte (N₂) dans ledit réservoir source (16) pour pressuriser ledit réservoir source (16) pour entraîner le transfert dudit réactif (14) dudit réservoir source (16) vers ledit récepteur (48).

5. Système selon la revendication 1, comprenant des moyens pour purger ledit réactif de traitement résiduel des conduits de distribution/alimentation en utilisant une purge de cycle à vide ou une purge de solvant pour assurer l'élimination du réactif.

6. Système selon la revendication 1, comprenant des moyens (20, 82) pour actionner automatiquement des robinets actionnés par le biais d'un des actionneurs pneumatique ou électrique.

7. Système selon la revendication 6, dans lequel lesdits robinets fonctionnent à partir de signaux générés par ordinateur envoyés à un actionneur de robinet.

8. Système selon la revendication 4, dans lequel lesdits moyens pour introduire un gaz inerte (N₂) dans ledit réservoir source (12) peuvent être adaptés pour introduire ledit gaz inerte (N₂) dans ledit récepteur (48) pour agir en tant que gaz porteur.

9. Système selon la revendication 1, dans lequel ladite sonde ultrasonore est disposée soit dans ledit réservoir source (12), soit placée sur une surface extérieure dudit réservoir (12), pour déterminer le niveau du réactif chimique (14) dans ledit réservoir source (12).

10. Système selon la revendication 1, comprenant au moins une ampoule (48) avec des détecteurs ultrasonores multiniveaux (68) en tant que récepteur (48) relié audit réservoir source (12).

11. Système selon la revendication 1, comprenant des moyens pour créer un vide partiel dans ledit récepteur (48) pour entraîner le déplacement du réactif chimique (14) dudit réservoir source (12) vers ledit récepteur (48), ou pour créer une pression positive sur ledit réservoir source (12) pour effectuer le transfert de réactif.

12. Système selon la revendication 1, dans lequel ledit récepteur (48) est un système à injection directe de liquide pour fournir de la vapeur réactive audit réacteur de traitement.

13. Système selon la revendication 12, comprenant une pluralité d'ampoules (48), chacune avec des détecteurs multiniveaux ultrasonores en tant que récepteur (48) relié audit réservoir source (12).

14. Système selon la revendication 1, dans lequel ledit récepteur (48) est une ampoule et comprend soit des moyens pour créer un vide partiel dans ladite ampoule pour entraîner un déplacement du réactif chimique de ladite ampoule (48) vers un réacteur de traitement de semi-conducteurs, soit des moyens pour fournir une pression positive au réservoir source (12) pour entraîner un transfert du réactif chimique.

15. Système selon la revendication 11, comprenant des moyens pour pressuriser ledit réservoir source (12) avec un gaz inerte (12) pour forcer le réactif (14) à se déplacer vers l'un d'un système à injection de liquide directe ou de contrôleurs de débit massique liquide.

16. Système selon la revendication 1, propre à la réalimentation en réactif chimique (14) choisi dans le groupe comprenant les précurseurs de TEOS, TEB, TMB, TMPI, TMPO, Cu(hfac)(TMVS) et ses divers mélanges, TDEAT, TDMAT, TiC14, DCE, TCA, POCI3, BBr3, PC13, TAETO, BTBAS, BST dissous dans des solvants de support, les matières solides nécessitant la liquéfaction telles que Cu(hfac)2, PGMEA, lactate d'éthyle, tous les autres précurseurs chimiques liquides et dopants qui sont liés au CVD, à la photorésine et au révélateur, et les opérations de diffusion.

17. Système selon la revendication 1, dans lequel les matériaux de construction pour le système sont choisis parmi le groupe comprenant l'acier inoxydable, le Téflon, l'Inconel, l'Hasteloy, le quartz, le verre, le plastique et autres matériaux qui ne réagissent pas avec le réactif chimique (14) devant être utilisé dans le système.

18. Procédé destiné à transférer un réactif chimique (14) d'un réservoir source (12) vers un récepteur (48) pour un réacteur de traitement de semi-conducteurs contenu à l'intérieur d'une pièce propre dans une installation de fabrication de semi-conducteurs utilisant un réservoir source (12) pour contenir une quantité brute dudit réactif (14), un ou plusieurs récepteurs (48) à partir desquels ledit réactif est distribué pour produire un effet sur un substrat semi-conducteur, un conduit de transfert (32) entre ledit réservoir (12) et ledit récepteur (48), un système de commande (20, 82) comprenant des moyens pour détecter les niveaux de liquide à l'intérieur dudit réservoir source (12) et dudit réservoir (48), **caractérisé en ce que** :
au moins une sonde ultrasonore (38) à l'intérieur dudit réservoir (12) ou placée sur une surface extérieure dudit réservoir (12) produit un signal lorsqu'un niveau de réactif (14) dans ledit réservoir (12) est atteint qui indique que ledit réservoir doit être réalimenté en ledit réactif ou remplacé par un réservoir plein (12);
ledit signal est conduit vers ledit système de commande (82) pour activer un d'un signal d'alarme, d'un voyant d'indication, ou d'un affichage numérique pour alerter un utilisateur qu'il doit s'occuper dudit réservoir ;
une sonde ultrasonore (64) dans ledit récepteur (48) produit un signal lorsqu'un niveau de réactif (14) dans ledit récepteur (48) est atteint qui indique que ledit récepteur doit être réalimenté en ledit réactif chimique (14) ; et
ledit signal provenant de ladite sonde ultrasonore (64) dans ledit récepteur (48) est utilisé pour entraîner le transfert dudit réactif chimique (14) dudit réservoir (12) vers ledit récepteur (48).

19. Procédé selon la revendication 18, dans lequel une sonde ultrasonore multiniveaux (38) à l'intérieur dudit réservoir source (12) produit des signaux indiquant un de trois niveaux de réactif liquide (14) à l'intérieur dudit réservoir (12), lesdits niveaux étant un premier niveau ou niveau plein, un deuxième niveau ou niveau partiellement plein et un niveau dans lequel le réservoir (12) doit être réalimenté ou remplacé.

20. Procédé selon la revendication 18, dans lequel une sonde de détection ultrasonore multiniveaux (64) dans chacun desdits récepteurs (48) produit des signaux distincts indiquant une condition à l'intérieur dudit récepteur (48) étant l'une des conditions d'avoir un niveau de réactif liquide indiquant que ledit récepteur (48) est plein, d'avoir un niveau de liquide indiquant que ledit récepteur (48) nécessite un transfert de réactif liquide dudit réservoir source (12) vers ledit récepteur (48), et d'avoir un niveau de réactif liquide indiquant que ledit récepteur (48) contient un niveau de liquide entre le niveau plein et le niveau nécessitant un transfert de réactif liquide dudit réservoir source (12) vers ledit récepteur (48), et dans lequel lesdits signaux sont acheminés vers ledit système de commande (20, 82) pour activer un ou l'ensemble d'un signal d'alarme, de voyants d'indication correspondant au niveau de réactif liquide dans ledit récepteur (48), d'affichages numériques dudit niveau de réactif liquide dans ledit récepteur (48) et du transfert de réactif liquide (14) dudit réservoir source (12) vers ledit récepteur (48).

21. Procédé selon la revendication 20, dans lequel lesdits signaux sont utilisés pour définir ledit système de commande (20, 82) de sorte à lancer automatiquement le transfert de réactif liquide (14) dudit réservoir source (12) vers ledit récepteur (48) lorsqu'un niveau bas présélectionné de réactif liquide est détecté dans ledit récepteur (48) et de sorte à terminer le transfert de réactif liquide lorsque ledit niveau plein est détecté dans ledit récepteur (48).

22. Procédé selon la revendication 18, dans lequel l'un d'un système à injection de liquide directe ou d'un système de distribution est installé en tant que récepteur (48).
